# EUROPEAN PATENT SPECIFICATION

(11) **EP 0 578 900 B1**
(45) Date of publication and mention of the grant of the patent: **05.11.1997**
(21) Application number: 92830383.3
(22) Date of filing: 16.07.1992
(51) Int. Cl.: G11C 11/412, G11C 8/00, G11C 11/419

(54) **Integrated CMOS static RAM**
Integrierter CMOS-statischer RAM
RAM statique CMOS intégrée

(43) Date of publication of application: 19.01.1994
(73) Proprietor: BULL HN INFORMATION SYSTEMS ITALIA S.p.A., 10014 Caluso (Torino) (IT)
(72) Inventor: Sada, Giancarlo, I-20099 Sesto S. Giovanni (MI) (IT); Silvano, Cristina, I-20099 Sesto S. Giovanni (MI) (IT)
(74) Representative: Falcetti, Carlo

(56) References cited:
- US-A- 4 768 172
- US-A- 4 873 665
- US-A- 4 910 712

## Description

The present invention relates to an integrated CMOS static RAM characterized by a hierarchical and modular structure resulting in high speed and flexibility in adaptation to ASIC requirements.

As known the acronyms CMOS,RAM and ASIC stand for "Complementary Metal Oxide Semiconductor, "Random Access Memory", "Application Specific Integrated Circuit".

US-A-4 768 172 discloses a memory cell which functions as a 3-port device (one write only port and two read only ports). The memory cell comprises a bistable circuit which consists of two inverters and has three bit lines and three word lines. One of the bit lines is used to write data into the memory cell and is connected to the input of the first inverter via a transfer gate which is responsive to a signal on a corresponding word line. The other two bit lines are used to read data from the memory cell and are both connected to the output of the first inverter via separate transfer gates and word lines.

The static RAM of the invention can also be implemented, in a preferred form of embodiment, as a dual, or multiport memory.

RAM memories, both single port and multiport are necessary in ASIC applications requiring on-chip shared or unshared memory resources, characterized by high speed and high level of integration.

In the ASIC design, the current trends are toward the utilization of "standard cells" whose physical layout, size performances and electrical parameters are predetermined, described in a computerized library and automatically compiled.

The design activity can therefore be limited to the architectural definition and results in a simple and fast verification of the project and its implementation, which can be made at a broad extent with automatic computerized processes.

In case of ASICs requiring on chip memories, this approach cannot be followed because the memory performances and design requirements are largely dependent on the global array dimension or memory capacity.

Therefore the memory cell design must be tailored to memory size and the speed requirements.

In addition to that the achievable performances are at large extent conditioned by the memory size, and the operative speed of the memory is always inversely related to the memory size.

These limitations are overcome by the integrated CMOS static RAM of the present invention which has an innovative architecture providing performances substantially independent of the global array dimension in the meantime rendering possible the use of memory cells having a fixed dimension and design, which cells too are innovative in design.

The present invention provides an integrated CMOS static RAM as defined in claim 1.

These advantages are achieved by an architecture based on a modular and hierarchical structure, where partial bit lines are used and specific circuits to disconnect the sub modules not directly involved in the current operation are intoduced.

Further the modular architecture and the separation of the bit lines for read and write operations offer further advantages in terms of used area optimization and operative speed because it allows for the usage of reduced size transistors in the basic cell and avoids the need of sense amplifiers and precharge circuitry usually present in static RAM, as well as of read clock signals.

The modular and hierarchical structure of the invention is based on memory cells arranged in structurally symmetrical pairs to form what may be considered basic elements of the structure.

The cell pairs are then linearly organized in N pair structures (where the number N of cell pairs is a predetermined number independent of the memory size and selectable for optimization of performances as a function of the used technology), to form a second level of the hierarchy.

The N pair structures are then grouped in parallel readable/writeable sets, in a number M depending on the required parallelism of the memory.

The sets of N pair structures are then organized in a plurality of submodules to form a third hierarchical level.

Therefore selection of the memory cells (addressing) is accomplished by three levels of decoding: sub-module,N pair structure within the sub module, and memory cell within the N pair structure.

The decoders can connect or disconnect the hierarchical levels by switching on or off some dedicated pass transistors. By turning on only pass transistors on the selected chain during the current operation, the capacitive load that the memory cell has to drive is reduced.

The features and the advantages of the invention will appear more clearly from the following description of a preferred form of embodiment and the enclosed drawings where:
- Figure 1 shows the electrical diagram of a memory cell pair designed in accordance with the present invention as basic element of the integrated CMOS static RAM of the invention.
- Figure 2 is a block diagram and layout diagram of an N pair structure in accordance with the invention.
- Figure 3 shows in block diagram a preferred form of embodiment of an integrated CMOS static RAM in accordance with the invention.
- Figure 4 shows in block diagram another form of embodiment of static RAM with a further hierarchical level in accordance with the invention.
- Figure 5 shows the electrical diagram of a memory cell pair designed in accordance with the present invention and supporting the implementation of dual port memories.

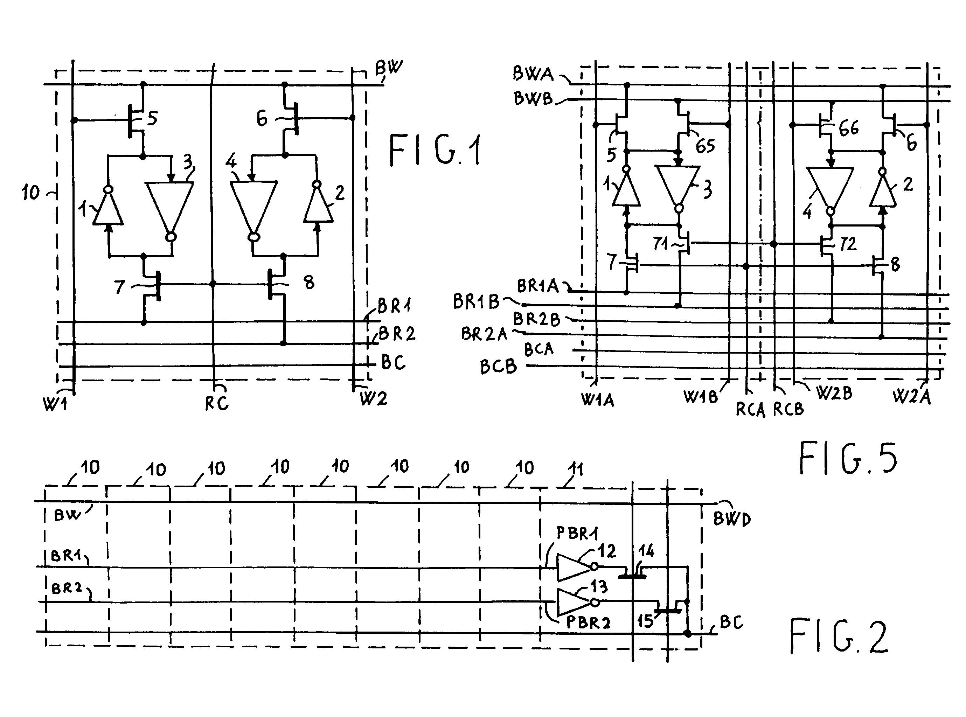

Figure 1 shows the electrical diagram of a memory cell pair designed in accordance with the present invention as basic element of the integrated CMOS static RAM of the invention.

Figure 1 may be considered as showing in somehow schematic form the effective layout of the cell pair.

Each memory cell in the pair comprises, in a known manner, a first inverter 1,2 respectively and a second inverter 3,4 respectively, the output of the first inverter 1,2 being coupled to the input of the second inverter 3,4 respectively; the output of the second inverter 3,4 being coupled to the input of the first inverter 1,2 respectively, to form an electrical, logical loop which (obviously when powered) self sustains its status.

A write control line W1 is vertically drawn at the left side of inverter 1 and is electrically connected to the control input of a pass gate 5 which couples the output of inverter 1 to a bit write line BW, horizontally drawn above the inverters and the pass gate 5.

Likewise a write control line W2 is vertically drawn at the right side of inverter 2 and is electrically connected to the control input of a pass gate 6 which couples the output of inverter 2 to the bit write line BW.

A read control line RC is vertically drawn in the middle of the cell pair and is electrically connected to the control input of two pass gates 7,8 respectively coupling the output of inverters 3 and 4 to a first bit read line BR1 and a second bit read line BR2 horizontally drawn below the inverters and the gates 7,8.

The dotted line 10 defines a rectangular area which may be considered the cell pair area required in laying out the structure on the semiconductor chip. The area is divided in two equal parts by the read control line RC, the two parts having a symmetrical layout as to the read control line RC (except for the connection of the pass gates 7,8 to the bit read lines).

Differently from the conventional memory cell structures, where selection of a cell is performed by row and column control signal lines used both for read and write operations, and the same bit line is used for both reading and writing information, in the cell pair shown in fig. 1 distinct control lines are used to select a cell for writing and to select a cell for reading as well as differing bit lines, for inputing bits to be stored or reading out stored bits.

Moreover a single read control line (RC) is used to select two cells at the same time, each driving the read information on its own bit read line BR1,BR2.

There are several implications resulting from the architecture shown in fig 1:
a first one is that, being the bit write line BW distinct from the bit read lines, each of the inverters 1 and 2 has only to drive the load formed by the output capacitance of pass gate 5,6 respectively and the input impedance of inverter 3,4 respectively.

Thus inverters 1 and 2 can be sized as very small components, and very little power is drained from them.

Another implication is that by providing two distinct bit read line BR1 and BR2, a single read control line RC can be used to select both cells of the pair, and the selection of one bit in the bit pair output from the cell pair can be performed by circuits which will be described later on.

Thus the extra space required to draw two bit read lines on the chip is compensated by the saving in the read control lines.

It is further clear that the size of inverters 3,4 must be adequate for driving the loads appended to the bit read lines which, being effectively and conceptually splitted, results in a load halving as to the prior art.

The load is further limited by the structural arrangement of the cell pairs in N pairs structures as described in the following.

Several memory cell pairs as the one shown in fig. 1, each referenced in the whole by numeral 10, are advantageously organized to form a N pair structure as the one shown in figure 2.

In Figure 2 eight cell pairs are linearly arranged in a rows and the bit write lines of each cell are connected together to form a bit write distributor BWD.

The bit read lines BR1 of the cell pairs are connected together to form a first partial bit read collector PBR1.

The bit read lines BR2 of the cell pairs are connected together to form a second partial bit read collector PBR2.

The N pair structure comprises, in addition to the 8 cell pairs a further cell 11 having a buffering and selecting function.

The cell 11 may be located at the left side or the right side as shown, and comprises a first and second inverters 12,13 performing the function of output buffers and two pass gates 14,15.

The input of the first buffer 12 is coupled to the first partial bit read collector PBR1. The input of the second buffer 13 is coupled to the second partial bit read collector PBR2.

The output of the first buffer 12 is connected to the input of the pass gate 14 and the output of the second buffer 13 is connected to the input of the pass gate 15.

The outputs of pass gates 14,15 are connected to a conductive line drawn at the base of the N pair structure and forming a full bit read collector BC.

Vertical selection line φ1,φ2 are drawn in the cell 11, and connected respectively to the control input of pass gate 14 and 15.

The electronic components of cell 11, shown as buffering inverters and pass gates, to clearly define their function as buffers and selection gates, can obviously be implemented as NAND gates, AND gates or NOR gates.

The architecture shown in Fig, 2 has several implication.

Since the partial bit read collectors are decoupled from the full bit read collector by the buffers 12,13, each inverter, such as 3 or 4 of the cell pairs, has to drive a load which is limited to the input impedance of the inverter 1 or 2 to which it is coupled and, through the related pass gate 7 or 8, to the predetermined impedance of the partial bit read collector to which it is coupled as it results from the partial bit read collector being connected to the output of a limited and predetermined number (N-1) of pass gates in switched off state and to the input of a buffer.

Therefore even inverters such as 3 and 4 may be sized as very small electronic components relative to a conventional dual inverter memory cell structure, although some how larger than inverters 1,2 and can achieve very fast switching performances, because of the limited load to be driven.

Moreover neither sense amplifier are required for read operation, nor precharge circuits.

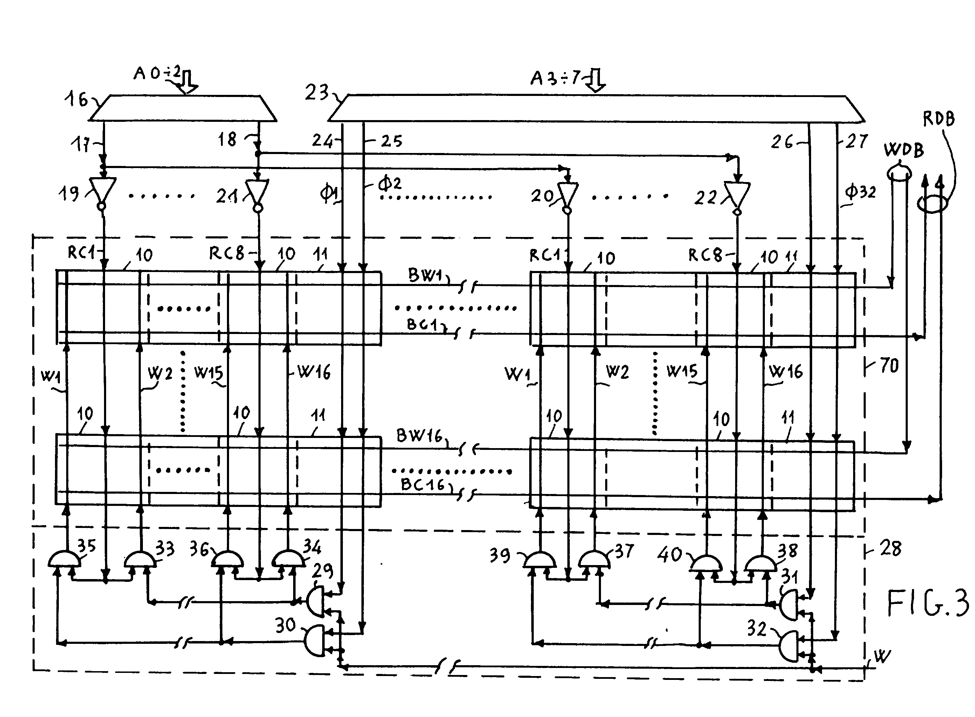

Figure 3 shows, by way of example a preferred form of embodiment of an integrated static RAM with hierarchical structure, having a capacity of 4K bit and parallelism of 2 bytes (16 bits).

The N pair structures comprise eight cell pairs each and the RAM is composed of 256 N pair structures.

The N pair structures are arranged in 16 columns, of 16 N pair structures, each column forming a set of structures which may be read or written in parallel. For sake of simplicity only two columns, and two structures per column are shown.

In each set the read control lines RC1 of the first cell pair of each structure are connected together and the same is for the read control lines of the second cell pair of each structure, of the third cell pair and so on.

For sake of simplicity, only read control lines RC1 and RC8 are shown.

The same is for write control lines W1,W2...W15,W16, of each cell which in the same set are respectively connected together.

For sake of simplicity only write control lines W1,W2,W15,W16 are shown.

The bit write distributor lines BW1 of the upper structure of each column are connected together, and the same is for the bit write distributor lines of correspondingly structures aligned in the same row of each column.

For sake of simplicity only lines BW1, BW16 are shown.

Similar connections are provided for the bit read collectors of the several structures, of which only collectors BC1 and BC16 are shown.

Selection of the cells where to read or write is performed by a first decoder 16, which receives as input a first portion of an address, comprising in the example bits A0-2 of an address.

Decoder 16 outputs on one of eight leads a selection signal. Only 2 leads 17,18 out of eight are shown for simplicity.

Lead 17 is connected to the input of 16 buffers, each one driving the read control line RC1 in each of the structure sets, Only buffers 19,20 are shown for simplicity.

All other leads are each connected to the input of 16 buffers, each one driving a read control line in each of the structure sets.

For clearness only lead 18 and its connection to buffers 21,22 are shown.

Thus for each addressing operation a cell pair in each of the N pair structures is read out and bit information made available on the partial bit read lines of the several structures.

Which information has to be output on the bit read collectors is established by a second level of decoding, which selects a set of structures among the several sets and either the first or the second cell of the selected pairs in each set.

The second level of decoding is performed by a second decoder 23, which receives as input a second portion of the address, comprising in the example bits A3-7 of the address.

Decoder 23 outputs on one of 32 leads (24,25,26,27 only are shown) a selection signal φ1,φ2,...φ32 respectively, which enables a pass gate (such as 14,15 in fig. 2) to connect a partial bit read line of a structure to the related bit read collector.

Enabling is performed in all the structures of the same set or column of structures.

Thus the selected set of structures outputs on the bit read collectors, which collectively form a parallel read data bus RDB, a parallel (two bytes) bit information.

This information may be output from the RAM block through suitable drivers, not shown, and in case of RAM addressing for a write operation may be ignored or even blocked at the output through suitable control gates not shown.

In the RAM architecture shown in fig. 3, write operations require write control circuits, collectively referenced by numeral 28 and comprising a plurality of AND circuits or equivalent control gates.

Leads 24,25...26,27 which select a structure set among the sets are respectively connected to an input of gates 29,30,.....31,32.

Each of these gates receive at a second input a write control signal W.

The output of gate 29 is connected to an input of a plurality of AND gates in number of 8, two of which are shown and referenced by numerals 33,34.

Gate 33 has a second input connected to the read control line RC1 of the first set of structures.

Gate 34 has a second input connected to the read control line RC8 of the first set of structures.

Other gates equivalent to gates 33,34 and not shown are connected to the other read control lines of the first set of structures.

The output of gate 30 is connected to an input of a plurality of AND gates in number of 8, two of which are shown and referenced by numerals 35,36.

Again, a second input of gates 35,36 is connected to the read control lines RC1,RC8 respectively of the first set of structures and similar connections are provided for the gates not shown.

The same control circuit architecture is provided for all other sets of structures and in particular, the output of gate 31 is connected to the input of AND gates 37,38 having a second input respectively connected to read control lines RC1, RC8 of the 16^{th} set of structures, whilst the output of gate 32 is connected to one input of AND gates 39,40 having the second input connected to read control lines RC1,RC8 of the 16^{th} set of structures.

The output of the several gates, such as 33,34...39,40 is connected to a different one of the several write control lines W1,W2...W15, W16 of the several sets.

It is therefore clear that the write control circuits, in response to a write command W and to an address decoded by decoders 16,23 provide the selection of one cell in each of the structures of the same column and allows the writing therein of two information bytes input through the several bit write distributors, BW1,......BW16 collectively forming a write data bus WDB.

The essential feature of this RAM architecture is that each level of selection has to drive connection lines having a limited length an a limited load.

For instance each output of decoder 16 has to drive a limited number of buffers and each buffer has to drive a limited number of read pass gates and two AND gates, such as 33,35.

Likewise each output of decoder 23 has to drive a limited number of pass gates in a single set of structures, plus two AND gates, such as 29,30.

Loading of the active elements of the RAM is therefore evenly distributed and leads to optimization and standardization of the active elements in terms of size, performaces, and adaptation to specific requirements by use of the same basic structural blocks.

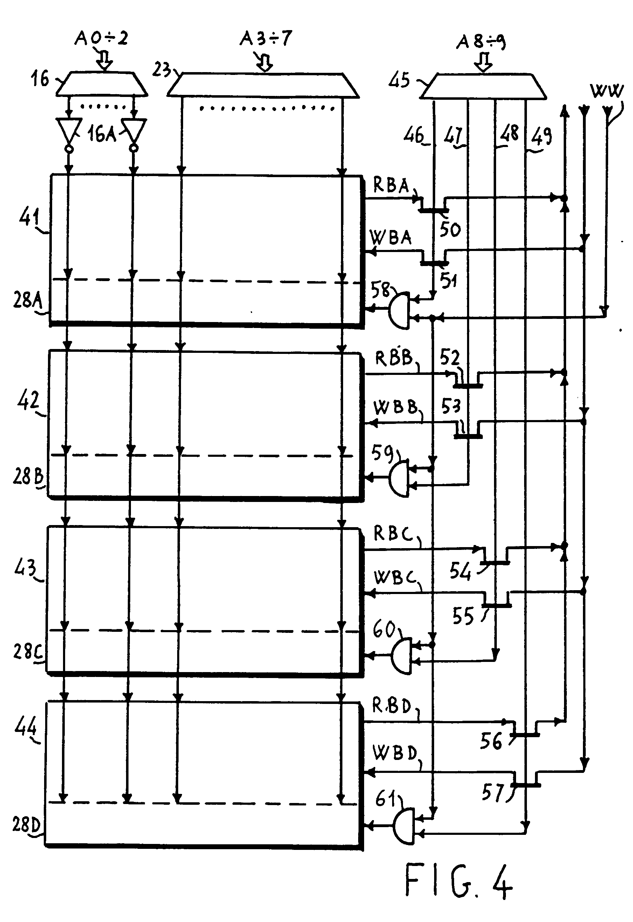

In particular, if the required RAM capacity exceeds a level which cannot be sustained by the even distribution of the loads achieved with two levels of decoding and the severing of the read/write paths, a third level of decoding can be added, as shown in Fig. 4.

In Figure 4 the RAM is organized in a set of submodules 41,42,43,44, each submodule comprising a plurality of N pair structures arranged as shown in Fig. 3 which may be considered a RAM organized in a single submodule globally referenced by numeral 70.

Each submodule 41,42,43,44 is provided with write control circuits 28A,28B,28C,28D each identical to the control circuits collectively referenced as 28 in Fig. 3.

A first decoder 16 with related buffers 16A and a second decoder 23 provide the same selection functions considered with referenced to Figure 3, but in this case extended to the plurality of submodules.

Each submodule has its own read bus RBA,RBB,RBC,RBD respectively and its own write bus WBA,WBB,WBC.WBD.

A third decoder 45, receiving for instance bits A8-9 of an address, provides on one of four output leads 46,47,48,49 a submodule selection signal which enables only the read, write buses of the selected submodule by means of gates 50,51,52,53...57.

The submodule selection signal is also used to enable a write command WW to pass to the selected submodule by means of AND gates 58,59,60,61.

In the preceding description the memory cell pair, the N pair structures and the RAM arrangement resulting from their use have been considered in relation to the embodiment of single port memories.

However the invention is not limited to single port implementations and is suitable for the implementation of multiple port memories. Fig. 5, in particular, shows the design of a cell pair supporting the implementation of a dual port memory.

In figure 5 the bit write line is duplicated in two bit write lines BWA,BWB.

Pass gate 5 is connected to the line BWA and is duplicated by the provision of another pass gate 65 connected to line BWB.

The same is for pass gate 6, connected to line BWA and having a duplicate 66 connected to line BWB.

Likewise the partial read bit lines BR1,BR2 are replicated (BR1A,BR2A,BR1B,BR2B) as well as the write lines (W1A,W2A,W1B,W2B).

The pass gates 7,8 of fig. 1 are replicated into pass gates 71,72 and 81,82 respectively and connected in the manner, shown in fig. 5, which is self exaplanatory, to the read control lines and the partial bit read lines.

Although not strictly necessary, replication of the decoders such as 16,23,45 and of the write control circuits such as 28 allows to design multiport RAMs where simultaneous access to all ports for read-write operations can be performed.

Contention arbitration logic preventing multiple simultaneous write access to the same location must be provided in this case.

The preferred number N of cell pairs forming a N pair structure is, at the current state of the CMOS technology, in the range from 8 to 16, but the expected improvements in the submicron technology lead to a possible increase of this range up to 32 or 64 as the most advantageous embodiment, in a near future.

## Claims

1. An integrated CMOS static RAM comprising a plurality of memory cells, each cell comprising a first inverter (1,2) and a second inverter (3,4), having an input and an output, the input of said first inverter being connected to the output of said second inverter, the input of said second inverter being connected to the output of said first inverter,
wherein
- said memory cells are arranged in structurally symmetrical pairs (10), linearly arranged in groups of N pairs to form N pair structures, where N is an integer greater than or equal to 1,
- each of said cells has a write control line (W₁,W₂),
- each of said cell pairs (10) has a bit write line (BW) a read control line (RC), a first bit read line (BR1) for a first cell (1,3) in said pair and a second bit read line (BR2) for the second cell (2,4) in said pair,
- each of said cells has a first pass gate (5,6) having a control gate connected to said write control line (W₁,W₂), for coupling the output of said first inverter (1,2) to said bit write line (BW),
- said first and second cell in each of said pairs, each have a second pass gate (7,8), having a control gate connected to said read control line (RC) for respectively coupling the output of said second inverter (3) of said first cell to said first bit read line (BR1) and the output of said second inverter (4) of said second cell to said second bit read line (BR2),
- said bit write lines in each of said N pair structures are connected together to form a bit write distributor (BWD),
- said first bit read lines (BR1) in each of said N pair structures are connected together to form a first partial bit read collector (PBR1),
- said second bit read lines (BR2) in each of said N pair structures are connected together to form a second partial bit read collector (PBR2), and
- each of said N pair structures includes a full bit read collector (BC), a first buffering and gating means (12,14) having an input coupled to said first partial bit read collector (PBR1) and an output coupled to said full bit read collector (BC), a second buffering and gating means (13,15) having an input connected to said second partial bit read collector (PBR2) and an output coupled to said full bit read collector (BC), said first and second buffering and gating means each having a control input (φ₁,φ₂) for receiving a control signal.

2. An integrated CMOS static RAM as in claim 1, where said first inverter (1,2) is smaller in size than said second inverter (3,4).

3. An integrated CMOS static RAM as in Claim 1 where said write control line (W₁,W₂), said bit write line (BW), said read control line (RC), said first and second read bit lines (BR1,BR2), said first and second pass gate (5-8) said bit write distributor (BWD) said first and second partial bit read collectors (PBR1,PBR2), said first and second buffering and gating means (12-15) and said full bit read collector (BC) are replicated with identical interconnections to provide a multiport capability.

4. An integrated CMOS static RAM as in claim 1 where said N pair structures are linearly arranged in a plurality of parallel readable/writeable sets of N pair structures, said full bit read collectors in each set forming a read collector parallel bus (RDB), said bit write distributors in each set forming a write distributor parallel bus (WBD).

5. An integrated CMOS static RAM as in claim 4, further comprising
- a first decoder (16) receiving a first portion of an address and outputting a bit selection signal, (17,18), at one of N outputs, each coupled, through buffering means (19-22) to one of said read control lines (RC) in every one of said N pair structures,
- a second decoder (23) receiving a second portion of an address and outputting: a parallel set of selection signals (φ₁,φ₃₂) at a plurality of outputs, each output being respectively connected to the control input of either said first or second buffering and gating means (12-15) in a related one of said parallel sets of N pair structures,
- write control means (28) receiving a write command (W) and coupled to said first and second decoder outputs and to said write control lines of all said cells, for receiving as an input said bit selection signal and said parallel set of selection signals and for outputting a write control signal on a said write control line of a set of cells selected in a parallel set of N pair structures.

6. An integrated CMOS static RAM as in claim 5 where said parallel sets of N pair structures are arranged in a plurality of sub modules (41-44), the read collector parallel busses of the same sub module being all connected together to form a sub module read data bus (RBA), the write distributor parallel busses of the same sub module being all connected together to form a sub module write data bus (WBA), said RAM further comprising
- decoding and control means (45) receiving a third portion of an address and selectively coupling, in response to said third address portion, the write data bus of a selected one among said sub modules and the read data bus of said selected submodule to input/output terminals of said integrated RAM, said decoding and control means further receiving a write command from an input terminal of said RAM and passing said write command to said write control means of said selected submodule.

## Patentansprüche

1. Ein statischer integrierter CMOS-RAM, der eine Mehrzahl von Speicherzellen aufweist, wobei jede Speicherzelle einen ersten Invertierer (1, 2) und einen zweiten Invertierer (3, 4) mit einem Eingang und einem Ausgang aufweist, wobei der Eingang des ersten Invertierers mit dem Ausgang des zweiten Invertierers verbunden ist, wobei der Eingang des zweiten Invertierers mit dem Ausgang des ersten Invertierers verbunden ist, wobei
die Speicherzellen in struktursymmetrischen Paaren (10) angeordnet sind, die in Gruppen von N Paaren linear angeordnet sind, um N-Paarstrukturen zu bilden, wobei N eine Ganzzahl ist, die größer oder gleich 1 ist,
jede der Zellen eine Schreibsteuerleitung (W1, W2) aufweist,
jedes der Zellenpaare (10) eine Bitschreibleitung (BW), eine Lesesteuerleitung (RC), eine erste Bitleseleitung (BR1) für eine erste Zelle (1, 3) in dem Paar und eine zweite Bitleseleitung (BR2) für die zweite Zelle (2, 4) in dem Paar aufweist,
jede der Zellen ein erstes Durchlaßgatter (5, 6) mit einem Steuergatter, das mit der Schreibsteuerleitung (W1, W2) verbunden ist, zum Koppeln des Ausgangs des ersten Invertierers (1, 2) mit der Bitschreibleitung (BW) aufweist,
die erste und zweite Zelle in jedem der Paare jeweils ein zweites Durchlaßgatter (7, 8) mit einem Steuergatter aufweisen, das mit der Lesesteuerleitung (RC) verbunden ist, zum jeweiligen Koppeln des Ausgangs des zweiten Invertierers (3) der ersten Zelle mit der ersten Bitleseleitung (BR1) und des Ausgangs des zweiten Invertierers (4) der zweiten Zelle mit der zweiten Bitleseleitung (BR2),
die Bitschreibleitungen in jeder der N-Paarstrukturen miteinander verbunden sind, um eine Bitschreibverteilungseinrichtung (BWD) zu bilden,
die ersten Bitleseleitungen (BR1) in jeder der N-Paarstrukturen miteinander verbunden sind, um eine erste Teilbitlesekollektoreinrichtung (PBR1) zu bilden,
die zweiten Bitleseleitungen (BR2) in jeder der N-Paarstrukturen miteinander verbunden sind, um eine zweite Teilbitlesekollektoreinrichtung (PBR2) zu bilden, und
jede der N-Paarstrukturen eine Vollbitlesekollektoreinrichtung (BC) umfaßt, wobei eine erste Puffer- und Gattereinrichtung (12, 14) einen Eingang, der mit der ersten Teilbitlesekollektoreinrichtung (PBR1) gekoppelt ist, und einen Ausgang aufweist, der mit der Vollbitlesekollektoreinrichtung (BC) gekoppelt ist, wobei eine zweite Puffer- und Gattereinrichtung (13, 15) einen Eingang aufweist, der mit der zweiten Teilbitlesekollektoreinrichtung (PBR2) verbunden ist, und einen Ausgang aufweist, der mit der Vollbitlesekollektoreinrichtung (BC) gekoppelt ist, wobei die erste und die zweite Puffer- und Gattereinrichtung jeweils einen Steuereingang (Φ1, Φ2) zum Empfangen eines Steuersignals aufweisen.

2. Ein statischer integrierter CMOS-RAM gemäß Anspruch 1, bei dem der erste Invertierer (1, 2) kleiner dimensioniert ist als der zweite Invertierer (3, 4).

3. Ein statischer integrierter CMOS-RAM gemäß Anspruch 1, bei dem die Schreibsteuerleitung (W1, W2), die Bitschreibleitung (BW), die Lesesteuerleitung (RC) , die erste und die zweite Lesebitleitung (BR1, BR2), das erste und zweite Durchlaßgatter (5 - 8), die Bitschreibverteileinrichtung (BWD), die erste und zweite Teilbitlesekollektoreinrichtung (PBR1, PBR2), die erste und zweite Puffer- und Gattereinrichtung (12 - 15) und die Vollbitlesekollektoreinrichtung (BC) mit identischen Verbindungen unterteilt sind, um eine Mehrtorfähigkeit liefern.

4. Ein statischer integrierter CMOS-RAM gemäß Anspruch 1, bei dem die N-Paarstrukturen linear in einer Mehrzahl von parallelen lesbaren/schreibbaren Sätzen von N-Paarstrukturen angeordnet sind, wobei die Vollbitlesekollektoreinrichtungen in jedem Satz einen parallelen Lesekollektoreinrichtungsbus (RDB) bilden, wobei die Bitschreibverteileinrichtungen in jedem Satz einen parallelen Schreibverteileinrichtungsbus (WDB) bilden.

5. Ein statischer integrierter CMOS-RAM gemäß Anspruch 4, der ferner folgende Merkmale aufweist:
einen ersten Decodierer (16), der einen ersten Abschnitt einer Adresse empfängt und ein Bitauswahlsignal (17, 18) an einem der N Ausgänge ausgibt, die jeweils über eine Puffereinrichtung (19 - 22) mit einer der Lesesteuerleitungen (RC) in jeder der N-Paarstrukturen gekoppelt sind,
einen zweiten Decodierer (23), der einen zweiten Abschnitt einer Adresse empfängt und einen parallelen Satz von Auswahlsignalen (Φ1 - Φ32) an einer Mehrzahl von Ausgängen ausgibt, wobei jeder Ausgang jeweils mit dem Steuereingang entweder der ersten oder der zweiten Puffer- und Gattereinrichtung (12 - 15) in einem zusammenhängenden der parallelen Sätze der N-Paarstrukturen verbunden ist,
eine Schreibsteuereinrichtung (28), die einen Schreibbefehl (W) empfängt und mit dem ersten und dem zweiten Decodiererausgang und mit den Schreibsteuerleitungen aller Zellen gekoppelt ist, zum Empfangen des Bitauswahlsignals und des parallelen Satzes der Auswahlsignale als Eingangssignal und zum Ausgeben eines Schreibsteuersignals auf der Schreibsteuerleitung eines Satzes von Zellen, die in einem parallelen Satz der N-Paarstrukturen ausgewählt sind.

6. Ein statischer integrierter CMOS-RAM gemäß Anspruch 5, bei dem die parallelen Sätze von N-Paarstrukturen in einer Mehrzahl von Teilmodulen (41 - 44) angeordnet sind, wobei die parallelen Lesekollektoreinrichtungsbusse desselben Teilmoduls alle miteinander verbunden sind, um einen Teilmodullesedatenbus (RBA) zu bilden, wobei die parallelen Schreibverteilungseinrichtungsbusse desselben Teilmoduls alle miteinander verbunden sind, um einen Teilmodulschreibdatenbus (WBA) zu bilden, wobei der RAM ferner folgende Merkmale aufweist:
eine Decodier- und Steuereinrichtung (45), die einen dritten Abschnitt einer Adresse empfängt und als Reaktion auf den dritten Adressenabschnitt den Schreibdatenbus eines ausgewählten Teilmoduls aus den Teilmodulen und den Lesedatenbus des ausgewählten Teilmoduls mit den Eingangs/Ausgangsanschlüssen des integrierten RAM selektiv koppelt, wobei die Decodier- und Steuereinrichtung ferner einen Schreibbefehl von einem Eingangsanschluß des RAM empfängt und den Schreibbefehl zu der Schreibsteuereinrichtung des ausgewählten Teilmoduls durchläßt.

## Revendications

1. RAM statique CMOS intégrée comprenant une pluralité de cellules de mémoire, chaque cellule comprenant un premier inverseur (1, 2) et un deuxième inverseur (3, 4), ayant une entrée et une sortie, l'entrée dudit premier inverseur étant connectée à la sortie dudit deuxième inverseur, l'entrée dudit deuxième inverseur étant connectée à la sortie dudit premier inverseur,
dans laquelle
- lesdites cellules de mémoire sont agencées en paires structuralemen0t symétriques (10), agencées linéairement en groupes de N paires afin de former des structures de N paires, où N est un nombre entier supérieur ou égal à 1,
- chacune desdites cellules a une ligne de commande d'écriture (W1, W2),
- chacune desdites paires de cellules (10) a une ligne d'écriture de bit (BW), une ligne de commande de lecture (RC), une première ligne de lecture de bit (BR1) pour une première cellule (1, 3) dans ladite paire et une deuxième ligne de lecture de bit (BR2) pour la deuxième cellule (2, 4) dans ladite paire,
- chacune desdites cellules a une première porte de passage (5, 6) ayant une porte de commande connectée à ladite ligne de commande d'écriture (W1, W2) pour coupler la sortie dudit premier inverseur (1, 2) à ladite ligne d'écriture de bit (BW),
- lesdites première et deuxième cellules dans chacune desdites paires ont chacune une deuxième porte de passage (7, 8) ayant une porte de commande connectée à ladite ligne de commande de lecture (RC) pour coupler respectivement la sortie dudit deuxième inverseur (3) de ladite première cellule à ladite première ligne de lecture de bit (BR1) et la sortie dudit deuxième inverseur (4) de ladite deuxième cellule à ladite deuxième ligne de lecture de bit (BR2),
- lesdites lignes d'écriture de bit dans chacune desdites structures de N paires sont connectées ensemble afin de former un distributeur d'écriture de bit (BWD),
- lesdites premières lignes de lecture de bit (BR1) dans chacune desdites structures de N paires sont connectées ensemble afin de former un premier collecteur de lecture de bit partielle (PBR1),
- lesdites deuxièmes lignes de lecture de bit (BR2) dans chacune desdites structures de N paires sont connectées ensemble afin de former un deuxième collecteur de lecture de bit partielle (PBR2), et
- chacune desdites structures de N paires comprend un collecteur de lecture de bit totale (BC), un premier moyen tampon et de déclenchement (12, 14) ayant une entrée couplée audit premier collecteur de lecture de bit partielle (PBR1) et une sortie couplée audit collecteur de lecture de bit totale (BC), un deuxième moyen tampon et de déclenchement (13, 15) ayant une entrée connectée audit deuxième collecteur de lecture de bit partielle (PBR2) et une sortie couplée audit collecteur de lecture de bit totale (BC), lesdits premier et deuxième moyens tampon et de déclenchement ayant chacun une entrée de commande φ₁, φ₂ pour recevoir un signal de commande.

2. RAM statique CMOS intégrée selon la revendication 1, où ledit premier inverseur (1, 2) a une taille plus petite que ledit deuxième inverseur (3, 4).

3. RAM statique CMOS intégrée selon la revendication 1, où ladite ligne de commande d'écriture (Wl, W2), ladite ligne d'écriture de bit (BW), ladite ligne de commande de lecture (RC), lesdites première et deuxième lignes de lecture de bit (BR1, BR2), lesdites première et deuxième portes de passage (5 - 8), ledit distributeur d'écriture de bit (BWD), lesdits premier et deuxième collecteurs de lecture de bit partielle (PBR1, PBR2), lesdits premier et deuxième moyens tampon et de déclenchement (12 - 15) et ledit collecteur de lecture de bit totale (BC) sont copiés avec des interconnexions identiques afin de fournir une possibilité multiport.

4. RAM statique CMOS intégrée selon la revendication 1, où lesdites structures de N paires sont linéairement agencées en une pluralité d'ensembles à lecture/écriture parallèles de structures de N paires, lesdits collecteurs de lecture de bit totale dans chaque ensemble formant un bus parallèle de collecteur de lecture (RDB), lesdits distributeurs d'écriture de bit dans chaque ensemble formant un bus parallèle de distributeur d'écriture (WDB).

5. RAM statique CMOS intégrée selon la revendication 4, comprenant en outre
- un premier décodeur (16) recevant une première portion d'une adresse et produisant un signal de sélection de bit (17, 18) à une de N sorties, chacune étant couplée, par l'intermédiaire des moyens tampon (19 - 22) à l'une desdites lignes de commande de lecture (RC) dans chacune desdites structures de N paires,
- un deuxième décodeur (23) recevant une deuxième portion d'une adresse et produisant en sortie: un ensemble parallèle de signaux de sélection (φ₁ - φ₃₂) à une pluralité de sorties, chaque sortie étant respectivement connectée à l'entrée de commande desdits premier ou bien deuxième moyens tampon et de déclenchement (12 - 15) dans un ensemble associé desdits ensembles parallèles de structures de N paires,
- un moyen de commande d'écriture (28) recevant un ordre d'écriture (W) et couplé aux sorties desdits premier et deuxième décodeurs et aux lignes de commande d'écriture de l'ensemble desdites cellules, pour recevoir en tant qu'entrée ledit signal de sélection de bit et ledit ensemble parallèle de signaux de sélection, et pour produire en sortie un signal de commande d'écriture sur une dite ligne de commande d'écriture d'un ensemble de cellules sélectionné dans un ensemble parallèle de structures de N paires.

6. RAM statique CMOS intégrée selon la revendication 5, où lesdits ensembles parallèles de structures de N paires sont agencés en une pluralité de sous-modules (41 - 44), les bus parallèles de collecteur de lecture du même sous-module étant tous connectés ensemble afin de former un bus de données de lecture de sous-module (RBA), les bus parallèles de distributeur d'écriture du même sous-module étant tous connectés ensemble afin de former un bus de données d'écriture de sous-module (WBA) , ladite RAM comprenant en outre
- un moyen de décodage et de commande (45) recevant une troisième portion d'une adresse et couplant sélectivement, en réponse à ladite troisième portion d'adresse, le bus de données d'écriture d'un sous-module sélectionné parmi lesdits sous-modules et le bus de données de lecture dudit sous-module sélectionné à des bornes d'entrée/sortie de l,adite RAM intégrée, ledit moyen de décodage et de commande recevant en outre un ordre d'écriture provenant d'une borne d'entrée de ladite RAM et faisant passer ledit ordre d'écriture sur ledit moyen de commande d'écriture dudit sous-module sélectionné.
